# EUROPÄISCHE PATENTSCHRIFT

(11) **EP 0 588 894 B1**
(45) Veröffentlichungstag und Bekanntmachung des Hinweises auf die Patenterteilung: **19.07.1995**
(21) Anmeldenummer: 92912385.9
(22) Anmeldetag: 10.06.1992
(51) Int. Cl.: H05K 7/14

(54) **AUS EINZELNEN BAUGRUPPEN BESTEHENDE ELEKTRISCHE ANLAGE**
ELECTRICAL INSTALLATION CONSISTING OF INDIVIDUAL STRUCTURAL UNITS
INSTALLATION ELECTRIQUE CONSTITUEE DE COMPOSANTS INDIVIDUELS

(30) Priorität: 11.06.1991 AT 1170/91
(43) Veröffentlichungstag der Anmeldung: 30.03.1994
(73) Patentinhaber: BERNECKER, Erwin, A-5122 Ach (AT); RAINER, Josef, A-5131 Franking (AT)
(72) Erfinder: BERNECKER, Erwin, A-5122 Ach (AT); RAINER, Josef, A-5131 Franking (AT)
(74) Vertreter: Hübscher, Helmut, Dipl.-Ing.
(86) Internationale Anmeldenummer: AT9200074
(87) Internationale Veröffentlichungsnummer: WO9222997

(56) Entgegenhaltungen:
- EP-A- 0 236 711
- DE-U- 8 415 458
- DE-U- 8 626 971
- DE-U- 8 910 111
- US-A- 4 632 594
- US-A- 4 790 762

## Beschreibung

Die Erfindung betrifft eine aus einzelnen Baugruppen bestehende elektrische Anlage, insbesondere eine aus Modulen zusammengesetzte Steuerungsanlage gemäß dem Oberbegriff des Patentanspruches 1.

Eine derartige Anlage ist aus der EP-A-0 236 711 bekannt. Der Aufbau einer elektrischen Anlage aus einzelnen Baugruppen ermöglicht es, verschieden große und für verschiedene Anwendungen dienende Anlagen aus untereinander zumindest äußerlich gleichen bzw. ähnlichen Baugruppen zusammenzusetzen, wobei je nach Anlagengröße und dem vorhandenen Platz auch mehrere Baugruppenreihen übereinander angeordnet werden, wobei dann Schaltverbindungen zwischen den Reihen über Zwischenschienen oder -kabel vorgenommen werden.

Bei Anlagen nach der EP-A-0 236 711 werden verschieden große Rückwandelemente verwendet, deren Breite einem ganzzahligen Vielfachen eines Grundmodulmaßes entspricht, wobei dieses Grundmodulmaß durch die Breite eines ansteckbaren Gehäuses bestimmt ist und jedem Rückwandelement wenigstens zwei solcher Gehäuse zugeordnet werden. Ein Großteil der Funktionseinheiten der Anlage wird von den Rückwandelementen selbst aufgenommen. Steckanschlüsse für in den Gehäusen untergebrachte Elemente dieser Anlage sind in eigenen, an den Rückwandelementen befestigbaren Tragelementen angebracht. Die Gehäuse werden mit Hilfe von Anschlußsteckern und zusätzlich mit durch sie hindurch zu den Rückwandelementen geführten Befestigungsschrauben befestigt. Zur Halterung der Rückwandelemente an der Tragschiene wird eine selbsttätig einrastende Schnappverriegelung vorgesehen.Es ist nicht daran gedacht, die Rückwandelemente für sich auszubauen.

Ferner erfolgt die elektrische Leitungsverbindung der Baugruppen über externe Verdrahtungen, wobei in den meisten Fällen an den Rückwandelementen nach unten gerichtete Steckanschlüsse vorgesehen werden, in die Bandleiter mit entsprechenden Gegenstekkern eingreifen.

Aufgabe der Erfindung ist die Schaffung einer Anlage der eingangs genannten Art, die die Vorteile der bekannten Anlage, aber nicht deren Nachteile besitzt und bei der eine beliebige Aneinanderreihung auch unterschiedlich breiter Baugruppen bei leichter, auch einzelner Auswechselbarkeit der einzelnen Baugruppen und auch der Rückwandelemente möglich ist und für Rückwandelemente und Gehäuse nur wenige unterschiedliche Bauteile benötigt werden, wobei auch unterschiedlich breite Gehäuse aus nur wenigen Grundelementen herstellbar sind.

Die gestellte Aufgabe wird durch die Merkmale des Patentanspruches 1 grundsätzlich gelöst.

Bei der erfindungsgemäßen Ausführung sind beliebige Varianten in der Breite der Gehäuse im Rahmen beliebiger Vielfacher des Grundmodulmaßes möglich, wobei die Reihenfolge verschieden breiter oder gleich breiter Gehäuse beliebig gewählt und verändert werden kann. Auch Erweiterungen bzw. Umbauten oder Umorganisationen der Anlage werden einfacher möglich. Es kann nicht nur im Bedarfsfall jedes beliebige Rückwandelement nach Abnahme des entsprechenden Gehäuses von der Vorderseite der Anlage her ausgewechselt werden, sondern es ist auch möglich, die Rückwandelemente nur teilweise zu lockern und je nach Bedarf für die Aufnahme weiterer Rückwandelemente im Zwischenraum auseinander bzw. bei Entnahme eines oder mehrerer Rückwandelemente zur Schließung der dadurch gebildeten Freiräume zueinander zu verschieben und wieder zu befestigen.

Die Ausgestaltung nach Anspruch 2 gewährleistet eine einwandfreie Ausrichtung der Rückwandelemente zueinander und die aus den Elementen gebildete Rückwand der Anlage erhält eine erhöhte Stabilität. Trotzdem kann wegen der besonderen Ausgestaltung wieder jedes Rückwandelement für sich ausgewechselt werden. Dadurch, daß die Federklammern ebenso wie die Rückwandelemente selbst aus Kunststofformteilen bestehen, werden keine der Korrosion unterliegenden oder durch ihre Leitfähigkeit die elektrische Anlage störenden Metallteile benötigt.

Die in Anspruch 3 angegebene Befestigungsart für die Rückwandelemente ist nicht nur sehr einfach, sondern hat auch den entscheidenden Vorteil, daß das Ein- und Aushängen problemlos möglich wird, die Schwenkriegel aber in einer Zwischenstellung zwar schon den zugeordneten Schienenflansch übergreifen und damit das Rückwandelement an der Schiene sichern, aber noch eine Verschiebung des Rückwandelementes auf der Schiene zulassen, ehe es in der gewünschten Endstellung durch Festziehen des Schwenkriegels endgültig gesichert wird.

Durch eine Weiterbildung gemäß Anspruch 4 kann man leicht feststellen, ob der Schwenkriegel angezogen ist oder nicht. Man kann hier die Handhabe gegenüber dem Rückwandelement einfärben. Damit die Schwenkriegelstellung nach Abnahme des Gehäuses einer Baugruppe sicher von der Vorderseite des Rückwandelementes festgestellt werden kann.

Bei einer Weiterbildung gemäß Anspruch 5 kann man im Bedarfsfall bei einer Reihe von Rückwandelementen ab einem bestimmten Element die Schwenkriegel bis zu einem Reihenende lösen, so daß die Reihe auf der Schiene verschoben und ein neues Rückwandelement eingesetzt bzw. bei Entnahme eines Rückwandelementes die Reihe wieder geschlossen werden kann.

Für die elektrischen Verbindungen wird vorzugsweise eine Ausbildung gemäß Anspruch 6 gewählt. Zu jeder Baugruppe passende Gegensteckanschlüsse können montiert werden, ohne daß Veränderungen am Rückwandelement selbst notwendig werden. Bereits durch das Aneinanderschieben benachbarter Rückwandelemente werden die Kontaktanschlüsse für elektrische Leitungen, z. B. Versorgungsleitungen, Steuerleitungen, Erdungsleitungen und einen Datenbus hergestellt und diese Leitungen verlängern sich bei der Anreihung weiterer Rückwandelemente selbsttätig, so daß innerhalb der Reihe keine zusätzlichen Verdrahtungsarbeiten notwendig werden.

Damit auch für die Gehäuse der einzelnen Baugruppen ein Aufbau aus möglichst wenigen Grundelementen möglich wird, wird eine Ausgestaltung gemäß Anspruch 7 gewählt. Es werden hier für den Grundaufbau eines Gehäuses immer zwei gleiche Schalen benötigt, die gegebenenfalls nur durch Zwischenstücke verschiedener Breite zu beliebig breiten Gehäusen ergänzt werden. Alle diese Bauteile lassen sich relativ einfach herstellen, wobei trotzdem eine Anpassung an verschiedenste Anwendungfälle über Zusatzelemente möglich wird. Über solche Zusatzelemente kann auch das Aussehen der Frontansicht der Baugruppen und der aus ihnen aufgebauten Anlage nach den Bedürfnissen oder den ästetischen Forderungen verändert werden. Nach einer möglichen Ausgestaltung gemäß Anspruch 8 wird die Anordnung in der Modulgrundteilung auch deshalb gewählt, um in der Reihe eine gleichbleibende Teilung in der Modulbreite auf der Sichtseite einzuhalten.

Schwenk- und Schnapphalterungen für die Türen und zusätzlich zu den Türen vorgesehene Schau- oder Anzeigefenster können an die entsprechenden Ränder der Schalen bzw. Zwischenstücke angeformt sein. Überdies können die Schalen bzw. Zwischenstücke mit ins Gehäuseinnere ragenden Tragrippen oder Halterungsansätzen für Einbauelemente versehen sein und/oder angeformte Einschiebeführungen für Leiterplatten, Rechnermodule, Anzeigevorrichtung sowie auch kleinere, eigene Baugruppen aufnehmende Modulgehäuse aufweisen, so daß auch der Ausbau der einzelnen Baugruppen durch Zusammenstecken und Einstecken der sie bildenden Elemente ermöglicht wird.

Weitere Einzelheiten und Vorteile des Erfindungsgegenstandes entnimmt man der nachfolgenden Zeichnungsbeschreibung.

In der Zeichnung ist der Erfindungsgegenstand beispielsweise veranschaulicht. Es zeigen
- Fig. 1: ein Teilstück einer hier aus vier Baugruppen bestehenden elektrischen Anlage in Vorderansicht,

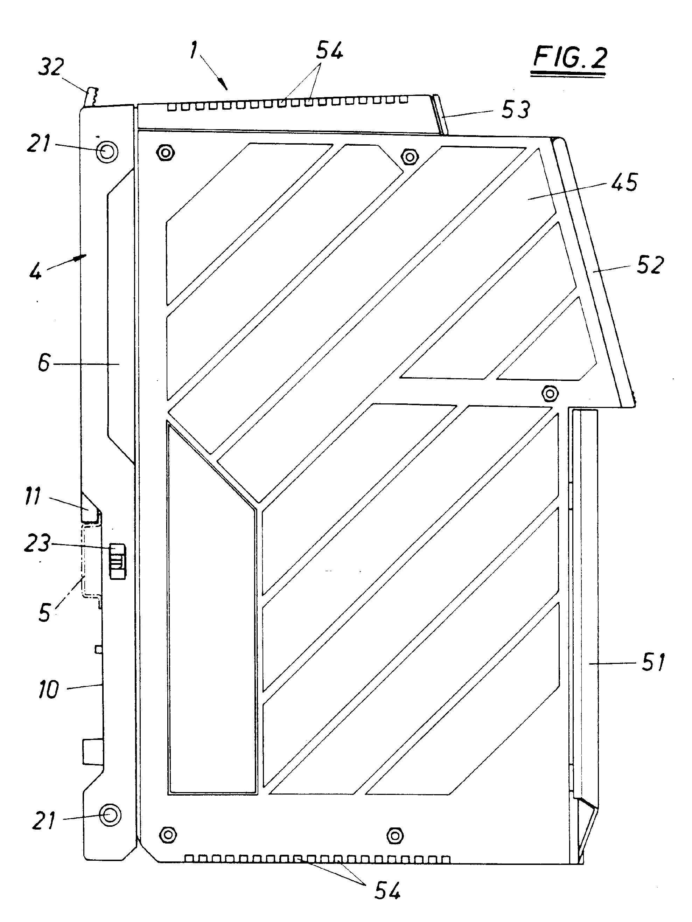

- Fig. 2: das Gehäuse einer Baugruppe in seiner an einem Rückwandelement montierten Stellung in Seitenansicht, wobei die Tragschiene nur in ihren Umrissen veranschaulicht wurde,
- Fig. 3: eine entsprechende Längsschnittdarstellung durch das Gehäuse,
- Fig. 4: eine Vorderansicht zu Fig. 2,
- Fig. 5: eine Rückansicht zu Fig. 2,
- Fig. 6: das Rückwandelement in Vorderansicht,
- Fig. 7: eine Draufsicht zu Fig. 2,
- Fig. 8: in schematischer Darstellungsweise einen am Rückwandelement zu befestigenden Träger mit Steckanschlüssen und
- Fig. 9: eine dem unteren Teil der Fig. 3 entsprechende Längsschnittdarstellung, wobei ein in das Modulgehäuse eingesetztes Gehäuse eines weiteren Bauteiles veranschaulicht wurde.

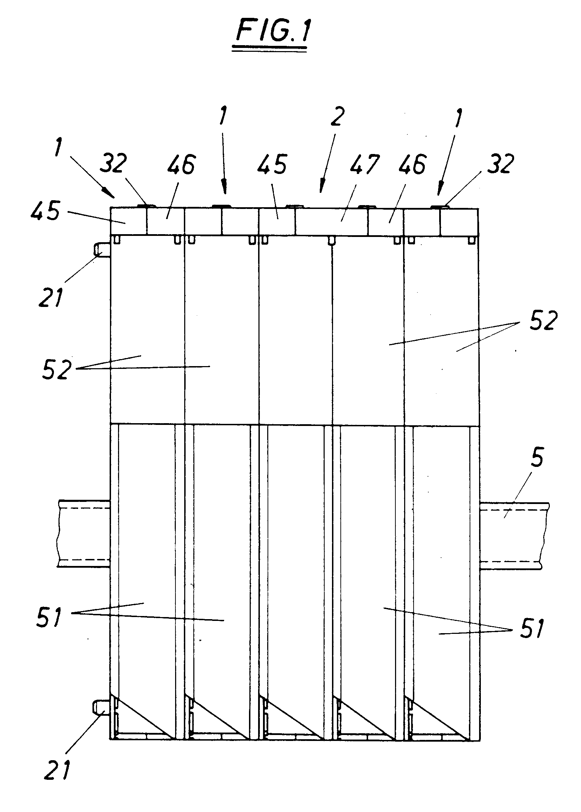

Nach Fig. 1 ist der dargestellte Teil einer elektrischen Anlage aus mehreren Baugruppen 1, 2 zusammengesetzt, wobei die die Baugruppen 1 untereinander gleiche Breiten und von außen gesehen identischen Aufbau besitzen, die Baugruppe 2 aber die doppelte Breite gegenüber den Baugruppen 1 hat. Die Baugruppen sind mit Hilfe von Rückwandelementen 4, die untereinander gleiche, den Baugruppen 1 entsprechende Breiten aufweisen, in einer Reihe nebeneinander befestigt, wobei die Rückwandelemente 4 ihrerseits auf einer tragenden, als Hutprofil ausgebildeten Profilschiene 5 angebracht sind.

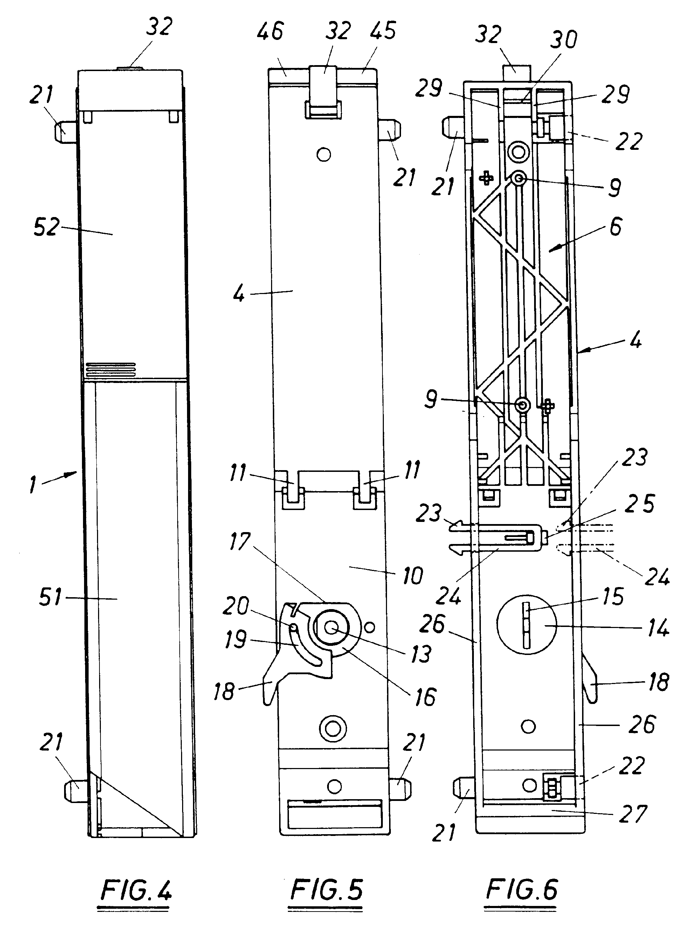

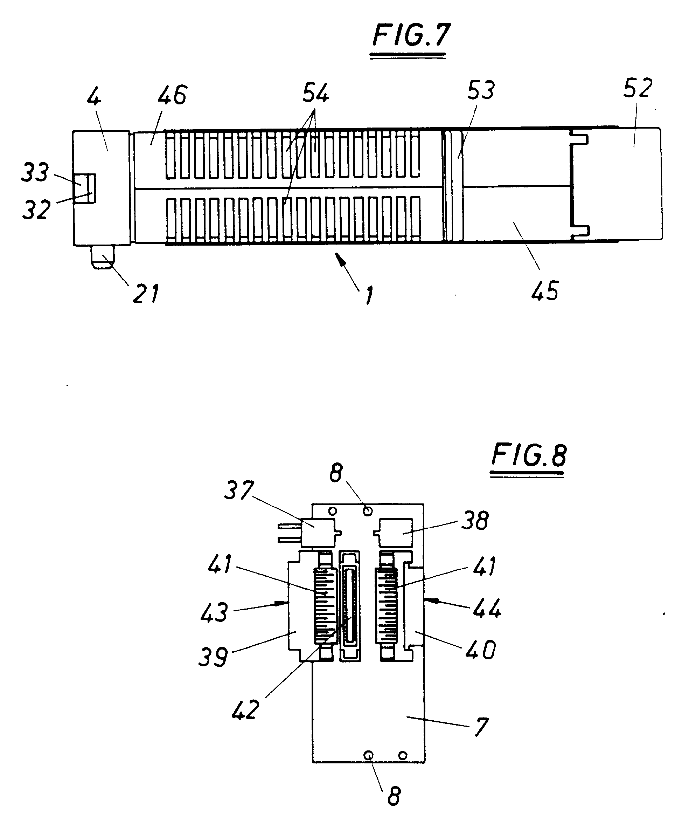

Jedes Rückwandelement 4 ist als Kunststofformteil ausgebildet und besitzt im oberen Bereich vorderseitig eine Vertiefung 6, an der, wie insbesondere Fig. 6 zeigt, nach vorne weisende Versteifungsrippen liegen, die auch wegen der Materialeinsparung vorgesehen sind und die als Auflage für eine Tragplatte 7 nach Fig. 8 dienen können, die mit Hilfe von durch Öffnungen 8 eingeführten Befestigungsschrauben, die in entsprechende Hülsenelemente 9 in der Frontseite der Rückwandelemente 4 eingreifen, befestigt werden.

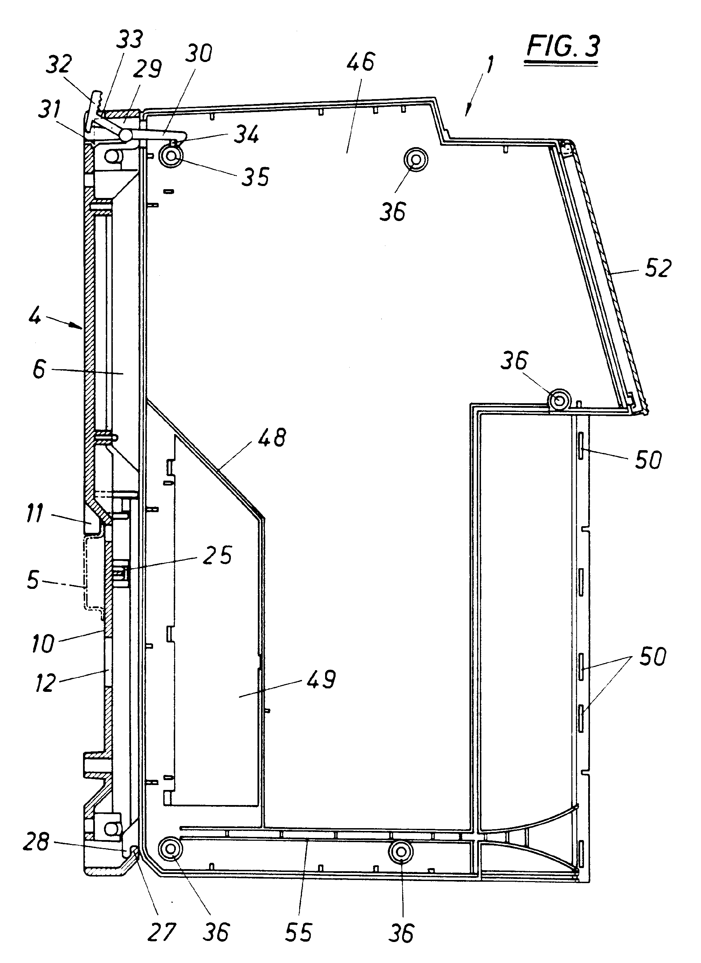

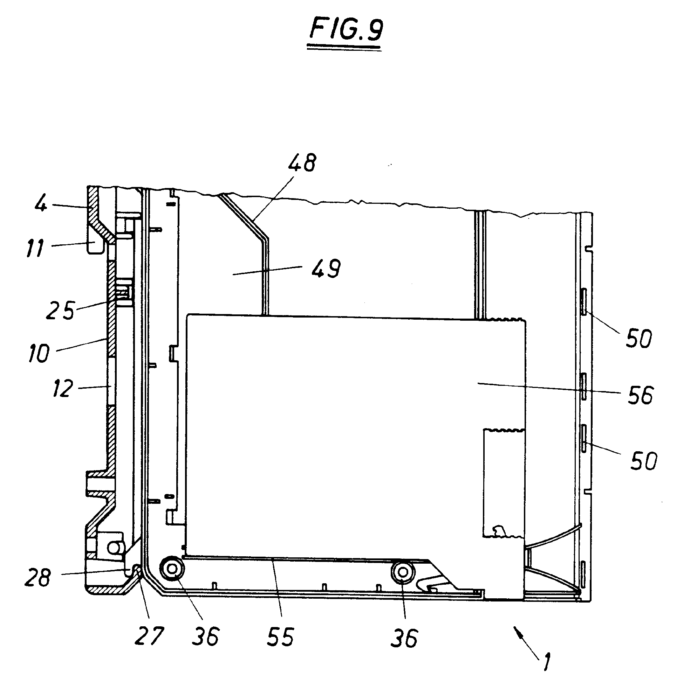

Auch im unteren Bereich des Rückwandelementes ist eine, hier von der Rückseite ausgehende Vertiefung 10 vorhanden, über die von oben her Einhängehaken oder Ansätze 11 für den oberen Flansch der Schiene 5 vorstehen. Eine Öffnung 12 (siehe Fig. 3 und 9) nimmt eine Schwenkachse 13 auf, auf der an der Frontseite des Rückwandelementes 4 eine Scheibe 14 mit einem auch als Stellungsanzeiger dienenden Einführschlitz 15 für eine Münze oder ein sonstiges Verdrehwerkzeug befestigt ist und die innerhalb der Vertiefung 10 an der Rückseite des Rückwandelementes einen Schwenkriegel 16 in Form eines einseitig nach einer Geraden 17 abgeschnittenen Kreises trägt und mit Hilfe einer Handhabe 18 verdrehbar ist, die an der einen Seite über das Rückwandelement vorragt und vorzugsweise in einer Signalfarbe gehalten ist. Der Schwenkriegel 16 ist ähnlich einer Taumel- oder Keilscheibe an seiner zur Rückwand der Vertiefung 10 weisenden Seite mit einer Keilfläche ausgestattet und läßt in der in Fig. 5 dargestellten Stellung ein Einhängen des Rückwandelementes 4 in die Hutschiene 5 zu, wobei durch Aufschwenken des Hebels 18 die Keilfäche der Scheibe 16 mit dem unteren Flansch der Hutschiene in Eingriff kommt und die Hutschiene gegen die Rückwand 10 festklemmt, wenn der Hebel 18 seine obere durch Langloch 19 und Anschlagstift 20 definierte Endstellung erreicht hat.

Die Rückwandelemente 4 besitzen oben und unten nach der einen Seite vorragende zapfenförmige Verbindungsstücke 21 und an der anderen Seite entsprechende Vertiefungen 22 für den Eingriff der Verbindungsstücke 21 der benachbarten Rückwandelemente. Wenn die Rückwandelemente voll aneinandergeschoben sind, kommen Hakenansätze 23 einer Federklammer 24, die an der Vorderseite des Rückwandelementes mit ihrem Steg in eine Rastaufnahme eingreift und deren Federschenkel durch seitliche Öffnungen in hochgezogenen Seitenrändern 26 des unteren Teiles des Rückwandelementes herausgeführt sind, mit der Rückseite entsprechende Löcher am anderen Seitenrand des benachbarten Rückwandelementes in Eingriff und klemmen so zwei benachbarte Rückwandelemente 4 aneinander. Da die Federschenkel 24 über der Rückseite des Rückwandelementes neben den hochgezogenen Seitenrändern 26 frei zugänglich sind, kann diese Schnappverbindung bei abgenommenem Gehäuse durch Zusammendrücken der Schenkel 24 gelöst werden.

Im untersten Bereich des Rückwandelementes 4 ist zwischen den Seitenrändern 26 ein Quersteg 27 hochgezogen, der in noch zu beschreibender Weise als Schwenklager für Befestigungshaken 28 an den Gehäusen 1, 2 dient. Im obersten Bereich des Rückwandelementes ist zwischen Seitenstegen 29 eine Führung für einen Schwenkhaken 30 gebildet, der sich mit dem Ende eines angeformten Federschenkels 31 in einer Rückwandöffnung abstützt und mit einer Handhabe 32 versehen ist, die auch zugleich zur Halterung dieses Schwenkhakens in einer passenden Öffnung 33 dient. Der Haken 30 kann durch Zurückdrücken der Handhabe 32 auf den Federschenkel 31 zu hochgeschwenkt werden. Die Teile 27 und 30 bilden miteinander die Haupthalterung für die Gehäuse 1 bzw. 2, wobei der Haken 30 auf einer Verrastungsrippe 34 einer durchgehenden Gehäusehülse 35 aufrastet. Weitere Gehäusehülsen 36 dienen für die Aufnahme von von Seitenwand zu Seitenwand des Gehäuses 1 bzw. 2 durchlaufenden Befestigungsschrauben, mit denen die Gehäuseteile zusammengehalten werden.

Auf der Tragplatte 7 sind oben ein Doppelstecker 37 auf der einen Seite und auf der anderen Seite eine Doppelsteckerbuchse 38 angebracht, die für die Herstellung von durchgehenden Leitungsverbindungen für die Energie bzw. als Masseleitung dienen und die beim Zusammenstecken der Rückwandelemente 4 selbsttätig mit den entsprechenden Steckern bzw. Buchsen der benachbarten Rückwandelemente 4 in Eingriff kommen. Unter diesen Elementen sind Vielfachdoppelstecker 39, 40 angebracht, die zur Frontseite gerichtete Vielfachsteckerzungen 41, 42 und nach links bzw.rechts gerichtete Vielfachstecker bzw. Steckeranschlüsse 43, 44 für die entsprechenden Gegenanschlüsse der benachbarten Rückwandelemente 4 aufweisen. Die Vielfachstecker 41, 42 wirken mit entsprechenden Vielfachsteckern bzw. Gegensteckern an Leiterplatten und entsprechenden in den Gehäusen 1, 2 untergebrachten Elementen zusammen und werden beim Ansetzen der Gehäuse 1 bzw. 2 an die Rückwandelemente automatisch in Eingriff gebracht. Die Doppelstecker 37 bzw. Steckerbuchsen 38 für die Energie- bzw. Masseleitung können nach einer Ausführungsvariante auch in die Vielfach-Doppelstecker 39, 40 integriert sein.

Die Gehäuse 1 bestehen jeweils aus zwei gegengleichen Schalenhälften 45, 46 (Fig. 1), wogegen das Gehäuse 2 aus zwei solchen Schalenhälften 45, 46 und einem die Breite eines Rückwandelementes 4 aufweisenden Zwischenstück 47 aufgebaut ist, das an die Schalenränder der beiden Schalenelemente 45, 46 anschließt, den Hülsen 35, 36 entsprechende Hülsen an Zwischenwandträgern befestigt hat und mit Hilfe von durch die Hülsen geführte Schrauben mit den Schalen zusammengehalten ist. Schalen und Zwischenstücke besitzen gegengleich ineinanderpassende Randprofile. An der zu den Rückwandelementen weisenden Seite sind Durchführungsöffnungen für die Gegenstecker (nicht dargestellt) und zur Durchführung der Haken 30 vorgesehen. Die Befestigung der Gehäuse 1, 2 an den Rückwandelementen erfolgt dadurch, daß die Haken 28 in 27 eingehängt und dann die Gehäuse aufgeschwenkt werden, bis die Haken 30 in die Rastrippen 34 einrasten.

In dem die eine Seitenwand eines Bauelementes bzw. Gehäuses 1 bzw. 2 bildenden Schalenelement 46 ist eine Öffnung 48 vorgesehen, über die der Gehäuseinnenraum erreichbar ist und die durch eine Schwenktüre 49 verschließbar ist, wobei die Scharnierelemente bei der Herstellung aus Kunststoff an Tür und Schale angeformt sind. Entsprechende angeformte Scharnierelemente 50 sind auch für eine Fronttür 51 vorgesehen, über die der untere Teil der Schale bzw. des Gehäuses 1 bzw. 2 zugänglich wird. Es können verschieden geformte Türen eingesetzt werden. Vorne ist der Oberteil der Gehäuse 1, 2 mit Aufnahmen für Schrägfenster 52 ausgestattet, hinter denen Anzeigeeinrichtungen angebracht werden können. Einschiebeführungen für Anzeigeschilder 53 sind im obersten Schalen- bzw. Gehäusebereich vorgesehen. Die zueinander gerichteten Schalenwandungen und auch die obere und untere Wandung des Zwischenstückes 47 ist zu einem Lüftungsgitter 54 ausgebildet. Überdies sind an den Schalen 45, 46 und auch über Trennwandfragmente im Zwischenstück Einschiebeführungen 55 vorgesehen, die etwa bei der Ausführung nach Fig. 9 ein einschiebbares Modulgehäuse 56 aufnehmen.

## Patentansprüche

1. Einzelnen Baugruppen (1, 2) enthaltende elektrische Anlage, bei der die einzelnen Baugruppen (1, 2) aneinanderreihbare Gehäuse aufweisen, für die Herstellung elektrischer Leitungsverbindungen mit Steckeranschlüssen für Gegensteckanschlüsse an einem Baugruppenträger (4) versehen sind, die Gehäuse am Baugruppenträger (4) über lösbare Halterungen (27, 30, 34) befestigt sind und der Baugruppenträger aus auf einer als Profilschiene (5) ausgebildeten Tragschiene aneinanderreihbar befestigbaren und untereinander in der Reihe verbindbaren Rückwandelementen (4) mit angeformten Halterungsansätzen (27, 33) für die Gehäuse (1, 2) selbst oder in diese Halterungsansätze einrastbaren Schnappverriegelungen (30) für die Gehäuse (1, 2) besteht, die Halterungen für die Gegensteckanschlüsse und Halterungs- bzw. Gegenhalterungsteile (27, 30) für die Gehäuse (1, 2) aufweisen und in ihrer Breite auf die Modulmaße der Gehäuse abgestimmt sind, insbesondere aus Modulen zusammengesetzte Steuerungsanlage, dadurch gekennzeichnet, daß die Gehäuse (1, 2) unterschiedliche, aber ein ganzzahliges Vielfaches eines Grundmodulmaßes betragende Breiten aufweisen, die Rückwandelemente (4) aber untereinander gleiche, dem Grundmodulmaß entsprechende Breite besitzen und an den Rückwandelementen (4) von der Vorderseite der Rückwandelemente her lösbare Verriegelungen (14, 15, 16) zum Halten der Rückwandelemente an der Tragschiene (5) vorgesehen sind.

2. Anlage nach Anspruch 1, dadurch gekennzeichnet, daß für die Verbindung der Rückwandelemente (4) mit benachbarten Rückwandelementen jeweils in das eine Element einrastbare, durch Seitenöffnungen aus den Elementen herausragende Federklammern (23, 24) und zugeordnete Einsatzöffnungen für die Halteschenkel der Federklammern des Nachbarelementes vorgesehen sind, wobei die Federklammern (23, 24) von der Frontseite des Rückwandelementes (4) her ausrastbare Federschenkel (24) aufweisen und aus Kunststofformteilen bestehen.

3. Anlage nach Anspruch 1 oder 2, dadurch gekennzeichnet, daß für eine als Hutprofilschiene (5) ausgebildete Tragschiene an der Rückseite der Rückwandelemente (4) je eine Aufnahmevertiefung (10) mit Einhängehaken (11) oder -flanschen für den einen Schienenflansch ausgeformt ist und daß für den zweiten Schienenflansch Schwenkriegel (16) an den Rückwandelementen (4) befestigt sind, die nach dem Einhängen der Rückwandelemente (4) in die Schiene über eine nach einer Seite über die Breite des Rückwandelementes vorragende Betätigungshandhabe (18) in eine Sperrstellung verschwenkbar sind, in der sie den Flansch mit einer Keilfläche übergreifen und festspannen.

4. Anlage nach Anspruch 3, dadurch gekennzeichnet, daß für den Schwenkriegel (16) eine zur Vorderseite des Rückwandelementes (4) geführte Schwenkachse (13) mit Stellungsanzeiger (14, 15) für den Schwenkriegel vorgesehen ist.

5. Anlage nach Anspruch 4, dadurch gekennzeichnet, daß der Stellungsanzeiger eine Scheibe (14) mit einer Einführöffnung (15) für ein Betätigungswerkzeug und/oder eine Münze ist, so daß der Schwenkriegel (16) von der Vorderseite des Rückwandelementes (4) her betätigt werden kann.

6. Anlage nach einem der Ansprüche 1 bis 5, dadurch gekennzeichnet, daß die Gegensteckanschlüsse (41, 42) für die Kontaktanschlüsse der Baugruppen (1, 2) an der einen Seite des Rückwandelementes (4) mit Steckanschlüssen (43) und an der anderen Seite des Rückwandelementes mit dort angebrachten Gegensteckanschlüssen (44) für die Steck- und Gegensteckanschlüsse benachbarter Rückwandelemente (4) verbunden und die Steck- und Gegensteckanschlüsse (37 bis 44) für die Baugruppen (1, 2) und die benachbarten Rückwandelemente (4) zu Doppelsteckerelementen (39, 40) vereinigt sind.

7. Anlage nach einem der Ansprüche 1 bis 6, dadurch gekennzeichnet, daß die Gehäuse (1, 2) je zwei Schalenhälften (45, 46) aufweisen, die einander bei der kleinsten Modulbreite zu dem Gehäuse ergänzen und zwischen denen bei größeren Modulbreiten an die Schalenwände anschließende Zwischenstücke (47) von ein ganzzahliges Vielfaches des Grundmodulmaßes betragender Breite angeordnet sind.

8. Anlage nach Anspruch 7, dadurch gekennzeichnet, daß die Gehäuse (1, 2) in der Modulgrundteilung vorgesehene Fensteröffnungen zur wahlweisen Aufnahme von Klapp- oder Schiebetüren (51) und/oder einsteckbaren Verschlußelementen aufweisen.

9. Anlage nach Anspruch 7 oder 8, dadurch gekennzeichnet, daß Schwenk- oder Schnapphalterungen (50) für die Türen (51) oder zusätzlich zu den Türen vorgesehene Schau- oder Anzeigefenster (52) an die entsprechenden Ränder der Schalen (45, 46) oder an Zwischenstücke (47) angeformt sind.

10. Anlage nach einem der Ansprüche 7 bis 9, dadurch gekennzeichnet, daß die Schalen (45, 46) oder Zwischenstücke (47) mit ins Gehäuseinnere ragenden Tragrippen (55) oder Halterungsansätzen für Einbauelemente (56) versehen sind.

11. Anlage nach Anspruch 10, dadurch gekennzeichnet, daß die Schalen (45, 46) oder Zwischenstücke (47) angeformte Einschiebeführungen (55) für Leiterplatten, Rechnermodule, Anzeigevorrichtungen und/oder kleinere, eigene Baugruppen aufnehmende Modulgehäuse (56) aufweisen.

## Claims

1. An electrical installation comprising individual structural units (1, 2), wherein the individual structural units (1, 2) comprise housings adapted to be arranged side by side in rows, are provided with plug connections for socket connections on a structural unit carrier (4), for making electrical cable connections, the housings are fixed on the structural unit carrier (4) via releasable mountings (27, 30, 34) and the structural unit carrier consists of back wall elements (4) which can be fixed side by side in a row on a carrier rail in the form of a profiled rail (5) and which are connectable to one another in the row, the said back wall elements (4) having integrally formed mounting lugs (27, 33) for the housings (1, 2) themselves or snap locking means (30) for the housings (1, 2), such snap locking means (30) being engageable in said mounting lugs, said back wall elements comprising mountings for the socket connections and mounting and companion mounting parts (27, 30) for the housings (1, 2) and being adapted in width to the housing module dimensions, more particularly a control installation composed of modules, characterised in that the housings (1, 2) have different widths which, however, are an integral multiple of a basic module dimension, but the back wall elements (4) have identical widths corresponding to the basic module dimension, and on the back wall elements (4) locking means (14, 15, 16) for holding the back wall elements are provided on the carrier rail (5), said locking means (3) being releasable from the front of the back wall elements.

2. An installation according to claim 1, characterised in that spring clips (23, 24) and associated insertion openings for the retaining limbs of the spring clips of the neighbouring element are provided for connecting the back wall elements (4) to neighbouring back wall elements, the said spring clips each being engageable in one element and projecting out of the elements through side openings, the spring clips (23, 24) comprising spring limbs (24) which are disengageable from the front of the back wall element (4) and consisting of plastic mouldings.

3. An installation according to claim 1 or 2, characterised in that for each carrier rail constructed as a rail (5) of hat-shaped profile there is formed on the back of the back wall elements (4) a reception recess (10) with engagement hooks (11) or flanges for one rail flange and in that for the second rail flange pivoting latches (16) are fixed on the back wall elements (4) and, after engagement of the back wall elements (4) in the rail, are pivotable, via a manipulator (18) projecting on one side beyond the width of the back wall element, into a locking position in which they engage over and clamp the flange by means of a wedge surface.

4. An installation according to claim 3, characterised in that for the pivoting latch (16) there is provided a pivot pin (13) which extends to the front of the back wall element (4) and which is provided with a position indicator (14, 15) for the pivoting latch.

5. An installation according to claim 4, characterised in that the position indicator is a disc (14) with an entry aperture (15) for an actuating tool and/or coin, so that the pivoting latch (16) can be actuated from the front of the back wall element (4).

6. An installation according to any one of claims 1 to 5, characterised in that the sockets (41, 42) for the contact connections of the structural units (1, 2) are connected to plug connections (43) on one side of the back wall element (4) and to socket connections (44) provided on the other side of the back wall element, for the plug and socket connections of neighbouring back wall elements (4) and the plug and socket connections (37 to 44) for the structural units (1, 2) and the neighbouring back wall elements (4) are combined to form double connector elements (39, 40).

7. An installation according to any one of claims 1 to 6, characterised in that the housings (1, 2) each comprise two halves (45, 46) which at the smallest module width complement one another to form the housing and between which, at larger module widths, intermediate members (47) adjoining the walls of the two halves are provided, said intermediate members being of a width equal to an integral multiple of the basic module dimension.

8. An installation according to claim 7, characterised in that the housings (1, 2) have window openings in the basic module pitch for the optional accommodation of flaps or sliding doors (51) and/or push-in closure elements.

9. An installation according to claim 7 or 8, characterised in that pivot or snap mounts (50) for the doors (51) or for inspection or indicator windows (52) provided in addition to the doors are integrally formed on the corresponding edges of the housing halves (45, 46) or intermediate members (47).

10. An installation according to any one of claims 7 to 9, characterised in that the housing halves (45, 46) or intermediate members (47) are provided with carrier ribs (55) projecting into the housing interior or mounting lugs for installation elements (56).

11. An installation according to claim 10, characterised in that the housing halves (45, 46) or intermediate members (47) have integrally formed guides (55) for the insertion of printed circuit boards, computer units, display units and/or smaller module housings (56) accommodating their own structural units.

## Revendications

1. Installation électrique contenant des groupes de construction (1, 2) individuels, dans laquelle les différents groupes de construction (1, 2) présentent des boîtiers pouvant être alignés en rangée les uns par rapport aux autres, pour la constitution de liaisons de lignes électriques, pourvus de raccordements à enfichage, destinés à des raccordements à enfichage conjugués situés sur un support de groupes de construction (4), les boîtiers situés sur le support de groupes de construction (4) étant fixés par l'intermédiaire de fixations (27, 30, 34) amovibles et le support de groupes de construction étant constitué d'éléments de paroi arrière (4), pouvant être fixés, en rangée, les uns contre les autres sur un rail support réalisé sous forme de rail profilé et pouvant être reliés les uns aux autres en série, avec des appendices de fixation (27, 23) formés sur eux pour les boîtiers (1, 2) eux-mêmes ou bien des verrouillages à encliquetage (30), pouvant être encliquetés dans ces appendices de fixation, pour les boîtiers (1, 2), présentant des fixations destinées aux raccordements à enfichage conjugués et les parties de fixation ou de fixation conjuguée (27, 30), pour les boîtiers (1, 2), et étant conçus quant à leur largeur, en fonction des dimensions modulaires des boîtiers, en particulier installation de commande composée par assemblage de modules, caractérisée en ce que les boîtiers (1, 2) présentent des largeurs différentes, mais qui sont un multiple entier des dimensions d'un module de base, les éléments de paroi arrière (4) ayant cependant les uns par rapport aux autres une largeur égale qui correspond à la dimension du module de base, et sur les éléments de paroi arrière (4) sont prévus sur la glissière-support (5) des verrouillages (14, 15, 16) amovibles depuis la face avant des éléments de paroi arrière, pour assurer la fixation des éléments de paroi arrière.

2. Installation selon la revendication 1, caractérisée en ce que, pour assurer la liaison des éléments de paroi arrière (4) à des éléments de paroi arrière voisins, sont prévues respectivement dans chaque élément, des pinces élastiques (23, 24) pouvant être encliquetées sortant par des ouvertures latérales hors des éléments et des ouvertures d'insertion associées pour les branches de fixation des pinces élastiques de l'élément voisin, les pinces élastiques (23, 24) présentant des branches de ressort (24) pouvant être décliquetées depuis la face avant de l'élément de paroi arrière (4) et étant composées de pièces moulées en matière synthétique.

3. Installation selon la revendications 1 ou 2, caractérisée en ce que, pour un rail support réalisé sous forme de rail à profil en chapeau (5), en face arrière de chaque élément de paroi arrière (4) est creusée une cavité de réception (10) avec des crochets ou des rebords d'accrochage (11), pour un rebord de glissière et en ce que, pour le deuxième rebord de glissière des verrous pivotants (16) sont fixés sur les éléments de paroi arrière (4) et, après accrochage des éléments de paroi arrière (4) dans la glissière, sont susceptibles de pivoter dans la glissière par l'intermédiaire d'une manette d'actionnement (18) dépassant d'un côté sur la largeur de l'élément de paroi arrière, le pivotement permettant le passage en une position de blocage dans laquelle ils saisissent par le dessus et bloquent par serrage le rebord, par une surface cunéiforme.

4. Installation selon la revendication 3, caractérisée en ce qu'un axe de pivotement (13) guidé en direction de la face avant de l'élément de paroi arrière (4) est prévu avec un indicateur de position (14, 15) pour le verrou pivotant.

5. Installation selon la revendication 4, caractérisée en ce que l'indicateur de position est un disque (14) avec une ouverture d'introduction (15) pour un outil d'actionnement et/ou une pièce de monnaie, de sorte que le verrou pivotant (16) peut être actionné depuis la face avant de l'élément de paroi arrière (4).

6. Installation selon l'une des revendications 1 à 5, caractérisée en ce que les raccordements à enfichage conjugués (41, 42) destinés aux raccordements par contact des groupes de construction (1, 2) sont reliés, sur un côté de l'élément de paroi arrière (4), à des raccordements à enfichage (43) et, sur l'autre côté de l'élément de paroi arrière, à des raccordements à enfichage conjugués (44) montés à cet endroit, pour les raccordements à enfichage et à enfichage conjugués d'éléments de paroi arrière (4) voisins et les raccordements à enfichage et à enfichage conjugués (37 à 44) destinés aux groupes de construction (1, 2) et les éléments de paroi arrière (4) voisins étant réunis pour constituer des éléments à enfichage double (39, 40).

7. Installation selon l'une des revendications 1 à 6, caractérisée en ce que les boîtiers (1, 2) présentent chacun des demi-coques (45, 46) qui se complètent mutuellement par rapport au boîtier, lorsqu'il s'agit de la plus petite largeur de module, et entre lesquelles sont disposées, lorsqu'il s'agit de plus grandes largeurs de modules, des pièces intermédiaires (47), se raccordant aux parois de coque et ayant une largeur constituant un multiple entier de la dimension du module de base.

8. Installation selon la revendication 7, caractérisée en ce que les boîtiers (1, 2) présentent des ouvertures formant fenêtres, prévues dans la division de base du module, pour recevoir à volonté des portes rabattables ou coulissantes (51) et/ou des éléments de fermeture enfichables.

9. Installation selon la revendication 7 ou 8, caractérisée en ce que les fixations à pivotement ou à encliquetage (50), destinées aux portes (51) ou à des fenêtres d'observation ou d'affichage (52) prévues en plus des portes, sont formées sur les bords correspondants des coques (45, 46) ou sur les pièces intermédiaires (47).

10. Installation selon l'une des revendications 7 à 9, caractérisée en ce que les coques (45, 46) ou les pièces intermédiaires (47) sont pourvues de nervures support (55) se projetant à l'intérieur du boîtier ou d'appendices de fixation pour des éléments à intégrer (56).

11. Installation selon la revendication 10, caractérisée en ce que les coques (45, 46) ou les pièces intermédiaires (47) présentent des guidages d'introduction par coulissement (55) pour des plaquettes à circuit imprimé, des modules d'ordinateur, des dispositifs d'affichage et/ou des boîtiers de module (56) plus petits recevant des groupes de construction propres
